## Europäisches Patentamt
## European Patent Office
## Office européen des brevets

(11) Numéro de publication: **0 016 246**
**B1**

(12)
# FASCICULE DE BREVET EUROPEEN

(45) Date de publication du fascicule du brevet: **19.01.83**

(51) Int. Cl³: **H 01 L 29/78, G 11 C 11/34**

(21) Numéro de dépôt: **79103773.2**

(22) Date de dépôt: **03.10.79**

(54) Structure semi-conductrice a effet de champ du type metal-isolant-metal ou metal-isolant-semi-conducteur et element de memoire comportant une telle structure

(30) Priorité: **15.02.79 US 12279**

(43) Date de publication de la demande:
**01.10.80 Bulletin 80/20**

(45) Mention de la délivrance du brevet:
**19.01.83 Bulletin 83/3**

(84) Etats contractants désignés:
**DE FR GB**

(56) Documents cités:
DE - A - 2 720 715
FR - A - 2 395 606
US - A - 4 104 675

IEEE TRANSACTIONS ON ELECTRON DEVICES, Vol. ED.26, No. 6, juin 1979 New York A. NEUGEBAUER et al. "Characteristics of Interface-Doped MNOS Memory Devices" pp. 893—898

(73) Titulaire: **International Business Machines Corporation**
**Armonk, N.Y. 10504 (US)**

(72) Inventeur: **Dekeersmaecker, Roger François**
**Amberlands Apt. 21H**
**Croton-on-Hudson New York 10520 (US)**
Inventeur: **Di Maria, Donelli Joseph**
**77 Carpenter Avenue, Apt. 24**
**Mt Kisco, New York 10549 (US)**
Inventeur: **Young, Donald Reeder**
**14 Briarbrook Road**
**Ossining, New York 10562 (US)**

(74) Mandataire: **Colas, Alain**
**COMPAGNIE IBM FRANCE Département de Propriété Industrielle**
**F-06610 La Gaude (FR)**

Courier Press, Leamington Spa, England.

# Structure semi-conductrice a effet de champ du type metal-isolant-metal ou metal-isolant-semi-conducteur et element de memoire comportant une telle structure

## Domaine technique

La présente invention concerne des structures semi-conductrices à effet de champ dans lesquelles la couche isolante a un intervalle de bande graduel permettant l'injection de trous ou d'électrons à partir d'un des interfaces de cette couche tout en bloquant l'injection d'électrons à partir de l'autre interface, cette couche isolante comportant une couche de piégeage pour capturer les trous et électrons. Elle concerne plus particulièrement une structure du type métal-dioxyde de silicium-silicium à oxyde graduel (GOMOS) pouvant fonctionner en tant qu'élément de mémoire.

## Etat de la technique antérieure

Les dispositifs du type FET (transistor à effet de champ) sont bien connus dans l'art antérieur. L'un de ces dispositifs utilise une structure $MI_1I_2S$ dans laquelle $I_1$ et $I_2$ représentent des première et deuxième couches isolantes. L'interface $I_1I_2$ peut comprendre une impureté métallique qui permet d'obtenir une région de piégeage d'électrons bien définie. La présence ou l'absence d'électrons piégés dans cette région permet de définir une fonction mémoire en utilisant comme paramètre soit des valeurs différentes de la capacitance de la structure, soit la valeur du courant source-drain qui varie en fonction des charges d'électrons piégées lorsque des tensions de porte sont appliquées d'une manière appropriées. Les impuretés métalliques à l'interface $I_1I_2$ ne sont pas toujours nécessaires, étant donné que le même effet peut être assuré par l'utilisation de deux types différents d'isolants. Par exemple, un des dispositifs connu dans l'art antérieur utilise une structure du type MNOS (métal-nitrure-oxyde-silicium) dans laquelle un film d'oxyde mince est tout d'abord formé sur un substrat de silicium, puis est recouvert par un dépôt de film de nitrure de silicium beaucoup plus épais. Dans cette structure, les électrons ou trous sont piégés dans la couch de nitrure de silicium. Cette structure particulière présente cependant un inconvénient lié à la couche d'oxyde mince. Cette couche d'oxyde doit être très mince, de l'ordre de 20 Å afin de permettre la migration, par effet tunnel, des électrons ou trous provenant du substrat de silicium. Des problèmes de fiabilité ont été rencontrés dans les dispositifs de mémoire comportant cette couche d'oxyde mince à effet tunnel en raison des champs élevés la traversant pendant son fonctionnement.

La demande de brevet No. 78 04977 déposé en France par la demanderesse le 15 février 1978 décrit un dispositif qui utilise une structure à intervalles de bandes graduels pour définir un dispositif d'emmagasinage de charge dans lequel il est possible d'injecter des trous ou des électrons à partir d'un contact tout en bloquant l'injection simultanée des électrons ou des trous depuis l'autre contact. Ce brevet présente une structure utilisant le principe de la réduction de l'intervalle de bande dans un transistor FET du type GOMOS qui assure une fonction mémoire. La structure GOMOS qui présente un configuration du type FET utilise le piégeage de trous au voisinage de l'interface $Si$—$SiO_2$. L'étape "d'écriture" implique l'injection de trous à partir de l'électrode de porte polarisée par une tension positive modérée, et leur transport à l'interface $Si$—$SiO_2$ où certains de ces trous, sont piégés d'une manière très stable. L'étape "d'effacement" implique l'injection d'électrons à partir de l'électrode de porte polarisée par une tension négative modérée et leur transport à l'interface $Si$—$SiO_2$, ces électrons supprimant les trous piégés. L'opération de "lecture" utilise la conductance de la surface de silicium pour détecter l'état de charge de la zone d'oxyde au voisinage de l'interface $Si$—$SiO_2$, des tensions de porte faibles étant utilisées pour éviter toute autre charge de cette zone.

La structure à intervalles de bandes graduels peut être fabriquée en formant, sur un couche de $SiO_2$ thermique relativement épaisse, plusieurs couches de $SiO_2$ pyrolythiques ou déposées chimiquement en phase vapeur, les couches de $SiO_2$ pyrolythiques présentant une teneur en $Si$ croissant séquentiellement. La structure peut également être fabriquée par implantation ionique contrôlée de $Si$ dans la couche de $SiO_2$ thermique. La structure peut encore être fabriquée en utilisant des couches de $SiO_2$ déposées par plasma, ces couches comportant une quantité graduelle de $Si$. Il est également possible d'utiliser d'autres couches isolantes présentant une injection de porteurs améliorée à partir de l'électrode de porte grâce à la réduction de l'intervalle de bandes réel ou à la réduction de l'intervalle de bandes effectif (par exemple par migration ou par effet tunnel assisté par piégeage).

Les dispositifs dont la structure est conforme à celle décrite dans la demande de brevet No. 78 04977 cité précédemment, présentent les inconvénients d'avoir la région de piégeage de charges subordonnée au procédé, de subir une détérioration de l'état de surface à l'interface $Si$—$SiO_2$ en raison du passage des trous, d'être sensibles à l'injection de porteurs "chauds" à partir du substrat de $Si$ en raison de la présence des trous piégés, et de requérir que l'injection et le piégeage des trous soient les premières opérations réalisées étant donné que les électrons ne peuvent pas être piégés sans la présence des trous.

## Exposé de l'invention

La présente invention pallie ces inconvénients en utilisant une structure à intervalle de bandes graduel ou successif amélioré pour réaliser un dispositif d'emmagasinage de charges dans lequel l'injection des trous ou des électrons à partir d'un contact est possible sans avoir à réaliser une injection de compensation d'électrons ou de trous à partir de l'autre contact. L'amélioration consiste dans l'inclusion d'une couche de piégeage de charges dans la région isolante épaisse adjacente au corps semi-conducteur de silicium. La couche de piégeage est située à une distance approximative de 50 Å ou plus de l'interface isolant-Si pour éviter la migration, par effet tunnel, des porteurs piégés de cette couche vers le substrat de Si.

Cette couche de piégeage capture et emmagasine soit des électrons (opération d'écriture), soit des trous (opération d'effacement) avec une efficacité proche de 100%, à la différence du dispositif présenté dans le brevet cité précédemment qui ne piège que les trous. Les électrons suppriment les trous piégés mais ils ne sont pas capturés lorsque les pièges à trous sont vides et dans un état de charge neutre. Dans la présente invention, les opérations d'écriture et d'effacement peuvent être interchangées lorsque les trous sont injectés en premier pour l'écriture et les électrons utilisés pour l'effacement.

La structure à intervalles de bandes peut être fabriquée par le procédé présenté dans le brevet cité précédemment. La structure est fabriquée en formant plusieurs couches de $SiO_2$, obtenues pyrolythiquement ou par dépôt chimique en phase vapeur, sur une couche de $SiO_2$ thermique relativement épaisse, les couches de $SiO_2$ pyrolythique présentant une teneur en Si croissant séquentiellement. La couche de piégeage peut être formée par implantation ionique d'impuretés, par diffusion de l'impureté dans la couche de $SiO_2$ thermique relativement épaisse ou par dépôt de l'impureté sur la couche de $SiO_2$ thermique, une couche stoichiométrique de $SiO_2$, déposée chimiquement en phase vapeur, isolant cette couche de piégeage de la région d'injection formée des couches de $SiO_2$ déposées chimiquement en phase vapeur et riches en Si.

D'autres objets, caractéristiques et avantages de la présente invention ressortiront mieux de l'exposé qui suit, fait en référence aux dessins annexés à ce texte, qui représentent un mode de réalisation préféré de celle-ci.

Brève description des figures

Les Figures 1a à 1c sont des représentations schématiques de bandes d'énergie à champ nul respectivement pour: a) les structures métal-isolant-semi-conducteur (type MIS) de l'art antérieur, b) les structures du type MIS à isolants étagé successifs (SIMIS), et c) structures du type MIS à isolant graduel (GIMIS).

Les Figures 2a à 2c sont des représentations schématiques de bandes d'énergie pour l'injection d'électrons de polarisation de porte négative à partir des électrodes de porte, et ce, pour les structures de la Figure 1.

La Figure 3 est une représentation schématique d'une bande d'énergie pour la polarisation de porte négative d'une structure du type GIMIS, montrant l'injection des électrons et leur capture ultérieure dans une couche de piégeage de charges introduites à cet effet, cette couche se trouvant dans l'isolant à large intervalle de bande au voisinage de l'interface isolant-silicium.

La Figure 4 est une représentation de la capacitance à haute fréquence en fonction de la tension de porte pour une structure du type SIMIS: (a) sortant de fabrication et non utilisée, (b), après injection et piégeage d'électrons et (c), après injections et piégeage de trous.

La Figure 5 est une vue en coupe d'une structure FET SIMIS réalisée selon les enseignements de la présente invention.

La Figure 6 est une vue en coupe d'une structure FET GIMIS réalisée selon les enseignements de la présente invention.

Mode de réalisations préférées

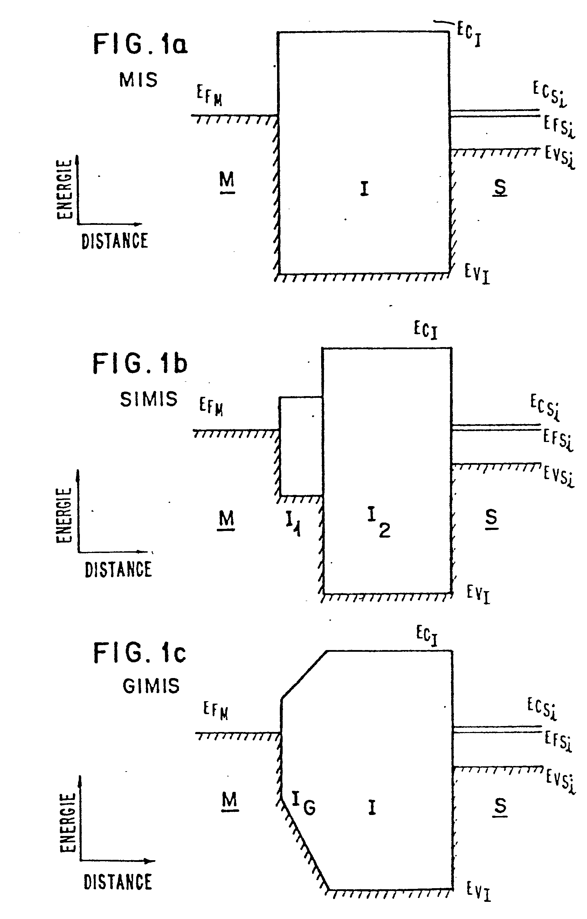

On va décrire maintenant un nouveau type de semi-conducteur pouvant être utilisé dans les mémoires à lecture seulement et dont le contenu peut être modifié électriquement (EAROM). Ce dispositif comporte un intervalle de bande d'énergie graduel ou successif situé au voisinage de l'électrode de porte métallique d'une structure du type MIS similaire à celle de la Figure 1a.

Les Figures 1b et 1c représentent des structures réalisées selon les enseignements de la présente invention. Avec ces types de structures, des électrons ou des trous peuvent être plus facilement injectés, à partir de l'électrode de porte, dans la couche isolante tout en appliquant une tension moindre. Les régions successives ou graduelles représentées sur le dessin sont minces par rapport à la région d'oxyde thermique, afin de réduire les effets de la charge d'espace piégée dans les régions successives ou graduelles, lorsque des champs électriques sont appliqués aux interfaces pour commander l'injection des porteurs et la détection de la charge.

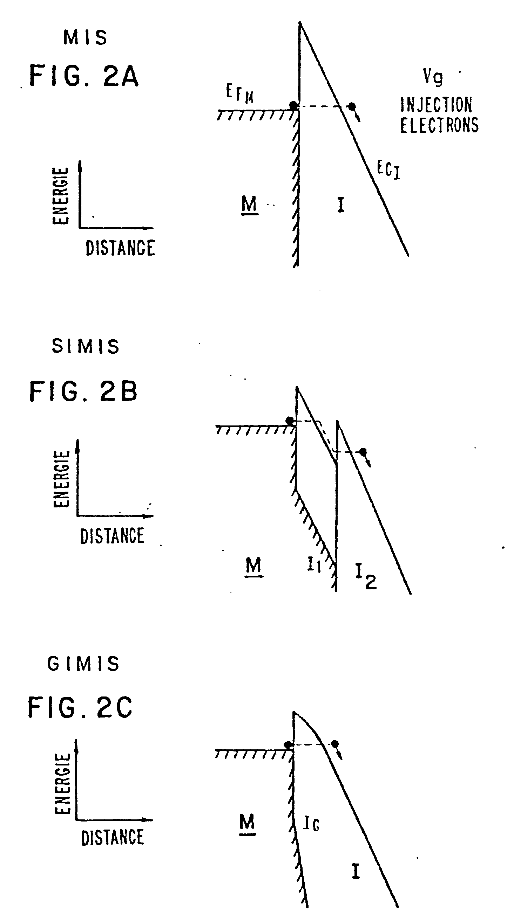

La Figure 2 représente l'effet de la polarisation de tension de porte négative (injection d'électrons) dans lequel le champ électrique moyen dans la masse de l'isolant à large intervalle de bandes est le même pour les Figures 2a, b et c. En clair, la structure GIMIS de la Figure 2c présente une meilleure injection que les structures MIS (Figure 2a) ou SIMIS (Figure 2b) en raison d'une barrière d'énergie plus faible à l'interface et donc d'une distance de migration par effet tunnel plus courte. La distorsion de bande dans la région successive (ou étagée) ou graduelle est classique pour des matériaux qui présentent tous de constantes électriques plus élevées que le $SiO_2$. L'injection d'électrons ou de trous, à partir du substrat semi-conducteur, ne se produira par simultanément en raison de l'intervalle de bande d'énergie plus important que "voient" ces porteurs pour les mêmes champs électriques moyens qui assurent l'injection (par migration par effet tunnel) à partir du contact de porte supérieur.

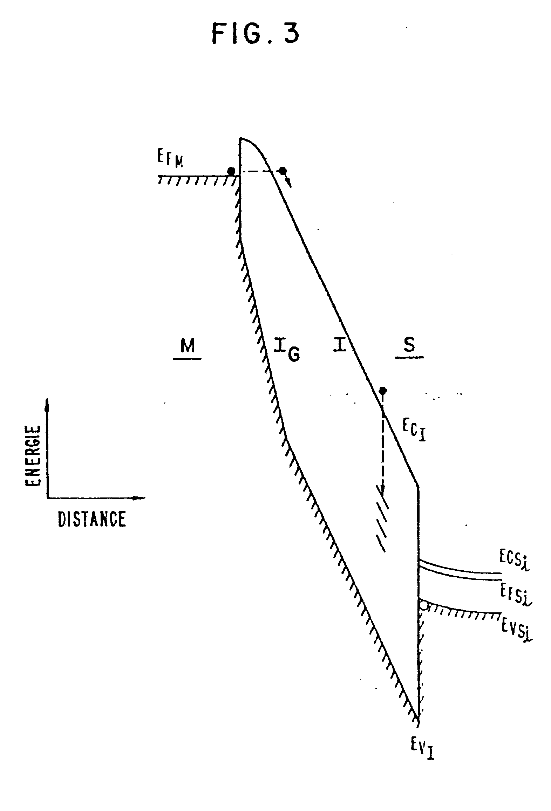

En utilisant le système MIS à isolant à intervalle de bande d'énergie graduel ou successif (ou étagé), on peut fabriquer une structure semi-conductrice non volatile qui n'utilise que l'interface substrat de Si/isolant pour détecter la charge d'emmagasinage (opération "lecture") dans une couche de piégeage de charges introduites à cet effet et située dans l'isolant à large intervalle de bandes d'énergie (commer montré à la Figure 3). Une implantation ionique d'arsenic ou de phosphore, un dépôt de faible épaisseur du tungstène et un dépôt de silicium polycristallin peuvent être utilisés pour cette couche de piégeage qui capturera soit les électrons, soit les trous injectés. L'opération "écriture" (ou "effacement") est assurée par l'injection d'électrons (ou de trous), ou vice versa, en utilisant à partir de l'électrode de porte, des champs électriques moyens faibles à modérés (2 à 5 MV/cm) pour la polarisation de tension négative (ou positive) et la capture ultérieure, de tous les électrons (ou trous) injectés dans la région de piégeage. La séparation des opérations de détection et de charge assure l'originalité de cette structure par rapport à d'autres types de structures de mémoire non volatile, telles que les structures du type métal-dioxyde de silicium-semi-conducteur (FAMOS) à effet d'avalanche et à porte flottante ou du type métal-nitrure de silicium-dioxyde de silicium-semi-conducteur (MNOS). Les dispositifs GIMIS et SIMIS présentent d'autres avantages par rapport à ces structures de mémoire, tels que:

1. Une faible tension est requise. Les champs locaux à l'interface substrat de Si/isolant sont faibles, la génération d'état d'interface devrait être réduite au minimum et cet interface ne devrait pas se détériorer. On croit que les structures MNOS se détériorent au cours de cycles en raison des champs électriques élevés existant à l'interface Si-tunnel SiO₂. Une faible puissance est aussi requise pour les structures GIMIS et SIMIS étant donné que des courants de Si importants ne sont pas requis comme dans les dispositifs de mémoire du type EAROM qui utilisent l'injection par avalanche à partir du Si pour charger des pièges tels que dans les structures FAMOS.

2. La génération d'état d'interface ou l'accumulation de charges piégées à l'interface Si—SiO₂, due à l'injection de porteurs "chauds" à partir du substrat de Si, ne se produira pas. Les structures FAMOS ou leurs variations connaissent ces problèmes qui limitent le nombre des cycles qu'elles peuvent supporter.

3. Les structures GIMIS ou SIMIS peuvent être électriquement "effacées" en peu de temps, avec le même type de rétention de charge que les dispositifs FAMOS. Les structures similaires aux structures FAMOS sont difficiles à effacer et requièrent de la lumière ultraviolette et de longues périodes de temps (de plusieurs minutes à plusieurs heures) pour "photo-dépiéger" des électrons situés sur la porte flottante elle-même enterrée dans la couche de SiO₂.

Dans une réalisation de la présente invention, on fabrique une structure pour montrer un fonctionnement du type GIMIS ou SIMIS. La structure fabriquée est une variante d'un dispositif MNOS. Cependant, contrairement aux structures MNOS qui présentent une couche de piégeage de Si₃N₄ épaisse pour emmagasiner la charge et une couche d'oxyde mince à effet tunnel, d'une épaisseur de l'ordre de 20 à 30 Å que l'on a fait croître sur le substrat de Si, les dispositifs SIMIS présentent des couches d'oxyde épaisse et de nitrure mince. La couche de Si₃N₄ mince (intervalle de bande de 5,2 eV constante diélectrique à basse fréquence de 7,5), est utilisée comme couche d'injection d'électrons ou de trous et non pas comme une couche d'emmagasinage de charge comme dans une structure MNOS classique. Le diagramme des bande d'énergie pour ce type de structure SIMIS est similaire à celui des Figures 1b et 2b. Dans ces structures SIMIS, on a fait croître les couches de SiO₂ thermiques (intervalle de bande de 9 eV, constante diélectrique à basse fréquence de 3,9) sur des substrats de Si (de type p-, à orientation <100> et ayant une résistivité de 2 Ω cm) à 1000°C dans du O₂ pour obtenir des épaisseurs comprises entre 400 et 1300 Å. Sur le sommet de la couche SiO₂, les couches de Si₃N₄ sont déposées chimiquement et en phase vapeur, à des épaisseurs comprises entre 25 et 600 Å, à 810°C, avec un rapport de NH₃/SiH₄ de 150/1.

La région de piégeage de charges est formée dans la couche épaisse de SiO₂ en implantant ioniquement de l'As avant le dépôt du Si₃N₄. Après l'implantation, une opération de recuit à 1000°C est effectuée dans du N₂ pendant 30 minutes pour supprimer tous les dommages pouvant être provoqués par la radiation, suivie par une opération de cuisson au gaz de formage pendant 30 minutes pour réduire les état de surface à l'interface Si—SiO₂. Puis la surface de SiO₂ est nettoyée et dégagée de tous métaux et hydrocarbures. Finalement, une électrode de porte métallique en aluminium est déposée sur la couche de Si₃N₄.

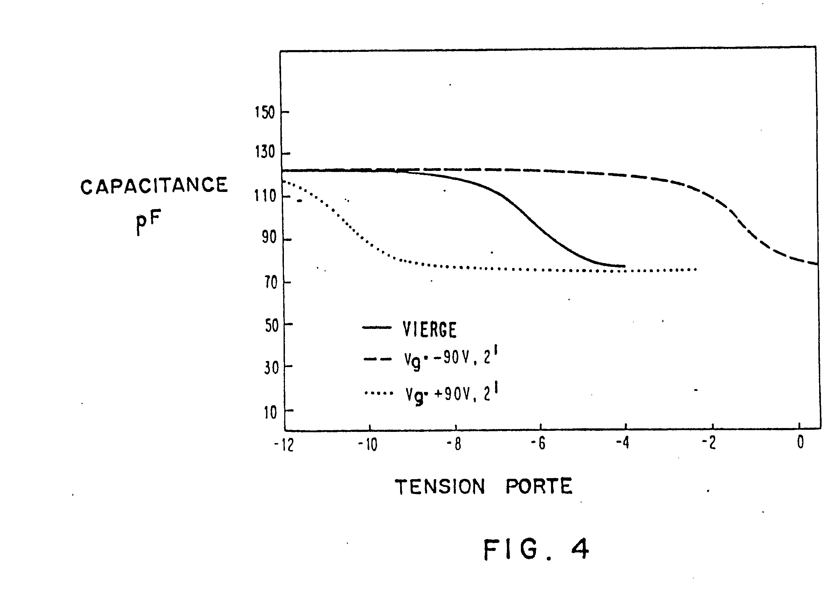

La Figure 4 représente schématiquement le fonctionnement "écriture" et "effacement" de l'une de ces structures SIMIS. Cette structure est formée à partir d'une couche de SiO₂ de 1334 Å et d'une couche de Si₃N₄ de 298 Å. Une implantation d'As, à une dose de $1 \times 10^{16}$ ions/cm² et pour une énergie de 40 KeV a été utilisée pour former la région de piégeage pour les électrons et les trous. Cette dose élevée a été utilisée pour assurer un piégeage à 100% des porteurs injectés. Des doses moins élevées qui ont été étudiées, ne se sont pas révélées aussi efficaces. Des tensions de porte négatives (ou positives), créant un champ moyen modéré dans la couche de SiO₂, ont été utilisées pour injecter des électrons (ou des trous) qui furent piégés en des points affectés par les implants d'As. Ceci provoqua un glissement des courbes tension/capacitance à fréquence élevée (1 MHz), vers des tensions plus positives (ou plus négatives) en raison du changement affectant les champs électriques internes tels que détectés par le substrat de Si. Sans régions de piégeage, on n'a constaté aucun effet d'emmagasinage de charges significatif dans les conditions de la Figure 4. La couche de Si₃N₄ fut maintenue aussi mince que possible par rapport à la couche d'oxyde, pour réduire au minimum les effets de charges d'espace piégés dans cette couche et qui pourraient limiter l'efficacité de l'injection.

Des structures à échelle réduite, similaires à celle de la Figure 4, ayant une épaisseur d'oxyde de 550 Å et une épaisseur de nitrure de 50 Å ont été également fabriquées. La couche de piégeage pour ces structures fut formée en utilisant une implantation d'arsenic sous 10 keV pour éviter le dopage de type n- du substrat de Si de type p-. Il ne fut pas possible d'obtenir des couches d'oxyde plus minces en raison de cet effet de dopage et les implantations sous faible énergie à des doses de 1 x 10¹⁶ ions/cm² furent également difficiles en raison des temps d'implantation impliqués. D'autres structures à épaisseurs d'oxyde et de nitrure et à énergie ionique comprises entre celles-ci et celles de la Figure 4, furent également fabriquées. Toutes les structures se comportèrent d'une manière similaire à celle de la Figure 4 dans des conditions comparables, les tensions appliquées décroissant avec l'épaisseur de l'isolant.

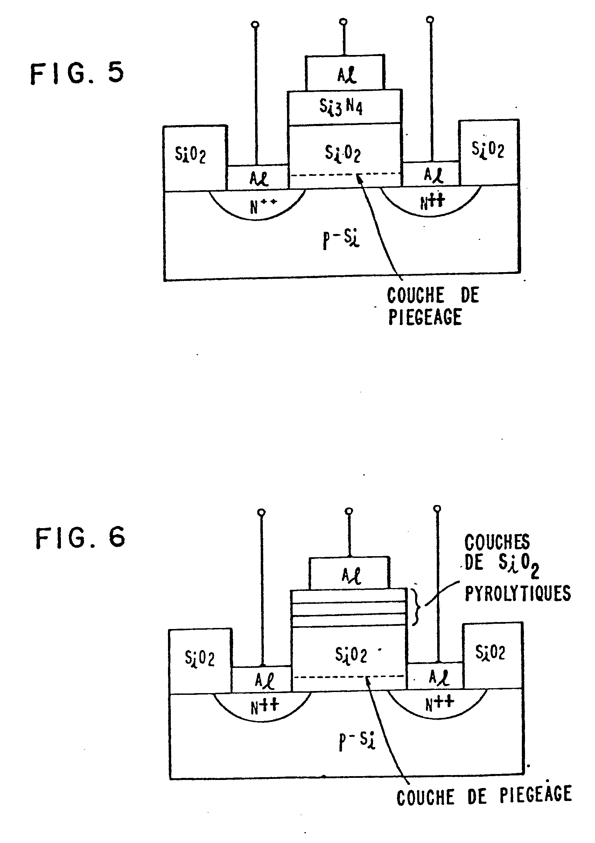

Les structures SIMIS décrites ici (voir la Figure 5), ayant des couches d'oxyde implantées ioniquement et une couche d'injection de Si₃N₄ à faible intervalle de bandes d'énergie, peuvent être utilisées cycliquement et répétitivement entre les états "écrits" et "effacés" après quelques premiers cycles. Une fois écrits, les effets de "perturbation de lecture" à température ambiante furent relativement faibles, avec un faible pourcentage de perte ou de compensation d'électrons piégés, considérant les faibles champs moyens requis pour des opérations de lecture réelle et utilisés dans une structure de transistor à effet de champ (FET).

Certaines structures FET préliminaires furent fabriquées en utilisant une couche d'emmagasinage de charge de Si polycristallin flottant, déposée sur du SiO₂ thermique, des couches de SiO₂ et Si₃N₄ minces étant déposées, chimiquement et en phase vapeur, entre celui-ci et une électrode de porte supérieure également en silicium-polycristallin. Ces structures changèrent d'état, fonctionnant comme des structures du type SIMIS, pour des tensions pouvant descendre jusqu'à 15V avec une "perturbation de lecture" minimale à des tensions inférieures à 6 volts.

On notera que dans ces structures du type à porte flottante, on peut trouver des régions d'injection séparées de la région porte.

Comme on le voit dans la Figure 2, une structure GIMIS constitue un injecteur de porteurs plus efficace qu'une structure SIMIS. Un intervalle de bande graduel peut être représenté comme un intervalle de bande étagé (ou successif) avec un nombre infini d'étages.

Un autre type d'injecteur utilisant une couche de SiO₂ déposé chimiquement en phase vapeur ou par plasma, à teneur en Si croissant graduellement et donc, à intervalle de bandes d'énergie et résistivité décroissants, peut également être fabriqué. On a constaté que les structures à dépôt chimique en phase vapeur constituent des injecteurs d'électrons extrêmement efficaces et des injecteurs de trous relativement bons. Dans ces structures, un courant d'électrons 10⁶ fois supérieur ou plus et un courant de trous approximativement 10² fois supérieur ont été observés pour des mêmes champs électriques moyens appliqués au SiO₂ thermique, par comparaison aux structures ne comportant pas la couche d'injection de SiO₂ déposée chimiquement en phase vapeur et riche en Si.

On peut également utiliser d'autres matériaux permettant de graduer la couche de SiO₂ jusqu'à un contact d'électrode de porte en poly-Si ou en métal, avec des constantes diélectriques à basse fréquence égales ou inférieures à celle du SiO₂ thermique (qui est égale à 3,9).

Les structures GIMIS les meilleures exigeraient la graduation complète du SiO₂ jusqu'à une électrode de porte supérieure de Si polycristallin. Ceci peut être assuré en utilisant les techniques de dépôt par plasma à basse température et non les techniques de dépôt chimique en phase vapeur par lesquelles 10% seulement de Si peut être incorporé dans le film de SiO₂.

Les dispositifs GIMIS peuvent être fabriqués selon le procédé présenté dans le brevet déjà cité précédemment. En général, la processus de frabrication se déroule de la manière suivante:

En partant d'un substrat de silicium monocristallin, on fait croître une couche isolante de SiO₂ thermique relativement épaisse sur laquelle on dépose chimiquement en phase vapeur, ou pyrolythiquement, des couches de SiO₂ successives. Trois de ces couches sont représentées dans la Figure 6 mais en fait un nombre quelconque de ces couches peut être utilisé. Chaque couche d'oxyde pyrolythique est relativement mince comparée à la couche isolante d'oxyde thermique complète et chaque couche d'oxyde pyrolythique successive comprend une quantité croissante de silicium. On sait que des couches d'oxyde pyrolythique, comportant du silicium en excès, peuvent être formées comme décrit par exemple dans le brevet des E.U.A. No. 3 649 884. Le nombre de couches pyrolythiques, l'épaisseur de chaque couche et la quantité de silicium en excès dans chaque couche successive, sont à choisir lors de la conception du dispositif.

La couche d'oxyde épaisse est implantée ioniquement pour former une couche de piégeage comme indiqué ci-dessus lors de la description de la structure du type SIMIS. Une couche de piégeage peut également être formée par diffusion ou par dépôt d'une impureté, par exemple du tungstène W, préalablement au dépôt chimique en phase vapeur du SiO$_2$. Cette impureté serait isolée de la région d'injection graduelle par une couche de SiO$_2$ stoichiométrique déposée chimiquement en phase vapeur.

Bien que l'on ait décrit dans ce qui précède et représenté sur les dessins les caractéristiques essentielles de l'invention appliquées à un mode de réalisation préféré de celle-ci, il est évident que l'homme de l'art peut y apporter toutes modifications de forme ou de détail qu'il juge utiles, sans pour autant sortir du cadre de ladite invention. Par exemple, bien que la réalisation préférée de la présente invention implique des structures MNOS et MOS, les enseignements de celle-ci peuvent être également appliquées aux structures métal-isolant-métal (MIM) ou MIS. De plus, bien que la structure de porte préférée de la présente invention ait été décrite come comprenant un contact d'aluminium, l'homme de l'art comprendra que d'autres métaux ou semi-conducteurs pourraient être utilisés. Plus particulièrement, du silicium polycristallin pourrait être déposé sur les couches d'oxyde pyrolythiques pour former le contact d électrode de porte.

## Revendications

1. Structure semi-conductrice à effet de champ et comportant un isolant à intervalle de bande graduel ou successif, du type métal-isolant-métal ou métal-isolant-semi-conducteur, dans laquelle l'isolant présente un faible intervalle de bande au voisinage d'un premier interface en contact avec l'électrode de commande pour former une région d'injection où, en fonction de la polarisation de la tension, des trous ou des électrons peuvent être injectés dans l'isolant, à partir du contact de ce premier interface et sous l'effet d'un champ électrique faible à modéré tandis que l'isolant présente un large intervalle de bande, au voisinage d'un deuxième interface en contact avec le substrat de la structure à effet de champ, pour empêcher l'injection d'électrons ou de trous à partir de ce deuxième interface et, l'épaisseur de l'isolant présentant un faible intervalle de bande étant mince par rapport à celle de l'isolant à large intervalle de bande, la structure semi-conductrice étant caractérisée en ce que: une couche de piégeage de charges est enterrée dans ledit isolant au voisinage dudit deuxième interface et ce, à une distance déterminée de cet interface pour empêcher la migration, par effet tunnel, des porteurs piégés vers le substrat, cette couche de piégeage capturant et emmagasinant les électrons ou les trous injectés et ce, avec une efficacité proche de 100%.

2. Structure semi-conductrice selon la revendication 1 caractérisée en ce qu'elle est du type métal-isolant-semi-conducteur comportant un substrat en silicium recouvert par ledit isolant et en ce que ledit isolant présentant un faible intervalle de bande consiste en un isolant présentant un intervalle de bande décroissant obtenu par implantation ionique.

3. Structure semi-conductrice selon la revendication 1 caractérisée en ce que le substrat est en silicium, ledit isolant présentant un large intervalle de bande est en SiO$_2$ et ledit isolant présentant un faible intervalle de bande est constitué par une mince couche de Si$_3$N$_4$ sur laquelle est réalisée le contact métallique.

4. Structure semi-conductrice selon la revendication 1 caractérisée en ce que le substrat est en silicium et ledit isolant présentant un faible intervalle de bande est constitué par plusieurs couches d'oxyde minces déposées pyrolytiquement ou par plasma et contenant une quantité croissante de silicium en excès.

5. Elément de mémoire caractérisé en ce que sa structure est définie selon l'une quelconque des revendications 1 à 4 et en ce qu'il comporte:
des régions de source et de drain réalisées dans le substrat semi-conducteur,
une structure de porte isolée formée entre les régions de source et de drain, l'intervalle de bande de l'isolant de la structure de porte n'étant réduit qu'au voisinage du contact électrique de porte pour former ladite région d'injection.

6. Structure semi-conductrice selon l'une quelconque des revendications précédentes caractérisée en ce que ladite couche de piégeage de charges est une couche flottante, à emmagasinage de charges et en silicium polycristallin.

## Claims

1. A semiconductor field-effect structure of the metal-insulator-metal or metal-insulator-semiconductor type, comprising a graded or successive band gap, wherein the insulator has a narrow band gap in the vicinity of a first interface in contact with the control electrode to provide an injection region where, depending on the voltage bias, holes or electrons can be injected into the insulator from the contact of said first interface under the effect of a low to moderate electric field, whereas the insulator has a wide band gap in the vicinity of a second interface in contact with the substrate of the field-effect structure to block the injection of electrons or holes from said second interface, the thickness of the insulator with a narrow band gap being reduced compared with that of the insulator with a wide band gap, said semi-

11  **0 016 246**  12

conductor structure being characterized in that:

a charge gettering layer is buried in said insulator in the vicinity of, and at a given distance from said second interface to prevent migration through tunneling of the gettered carriers towards the substrate, said gettering layer capturing and storing the injected electrons and holes with a near-to-100% efficiency.

2. A semiconductor structure according to claim 1, characterized in that it is of the metal-insulator-semi-conductor type comprising a silicon substrate coated with said insulator, and in that said insulator with a narrow band gap is an insulator whose decreasing band gap is obtained by ion implantation.

3. A semiconductor structure according to claim 1, characterized in that the substrate consists of silicon, said insulator with a wide band gap consisting of $SiO_2$ and said insulator with a narrow band gap consisting of a thin $Si_3N_4$ layer on which the metal contact is provided.

4. A semiconductor structure according to claim 1, characterized in that the substrate consists of silicon and in that said insulator with the small band gap is composed of several thin oxide layers deposited pyrolytically or by plasma and containing an increasing quantity of excess silicon.

5. A storage element, characterized in that its structure is defined according to any one of claims 1 to 4 and in that it comprises:

source and drain regions provided in the semiconductor substrate,

an insulated gate structure formed between the source and drain regions, the insulator band gap of the gate structure being reduced only in the vicinity of the electric gate contact to form said injection region.

6. A semiconductor structure according to any one of the preceding claims, characterized in that said charge gettering layer is a floating layer made of polycristalline silicon for charge storing.

**Patentansprüche**

1. Halbleiter-Feldeffektstruktur vom Metall-Isolator-Metall- oder vom Metall-Isolator-Halbleitertyp mit einem Isolator mit stufenweise oder kontinuierlich verändertem Bandabstand, in welcher der Isolator in der Nähe einer ersten, mit der Steuerelektrode in Kontakt befindlichen Grenzfläche einen kleinen Bandabstand aufweist, um einen Injektionsbereich herzustellen, in dem in Abhängigkeit von der Vorspannung und unter Einfluß eines schwachen bis mäßigen elektrischen Feldes Löcher oder Elektronen aus dem Kontakt in den Isolator injiziert werden können, wogegen der Isolator in der Nähe einer zweiten, mit dem Substrat der Feldeffektstruktur in Kontakt befindlichen Grenzfläche einen großen Bandabstand aufweist, um die Injektion von Elektronen oder Löchern aus dieser zweiten Grenzfläche zu verhindern, wobei die Dicke des Isolators mit einem kleinen Bandabstand gering ist verglichen mit der des Isolators mit einem großen Bandabstand, dadurch gekennzeichnet, daß:

eine Ladungsgetterschicht in diesem Isolator in der Nähe der zweiten Grenzfläche und in einem bestimmten Abstand von dieser Grenzfläche vergraben ist, um die Abwanderung der gegetterten Ladungen aufgrund des Tunneleffekts nach dem Substrat zu verhindern, wobei diese Getterschicht die injizierten Elektronen oder Löcher mit nahezu 100-prozentiger Wirksamkeit einfängt und speichert.

2. Halbleiterstruktur nach Anspruch 1, dadurch gekennzeichnet, daß sie vom Metall-Isolator-Halbleitertyp ist und ein mit diesem Isolator beschichtetes Siliciumsubstrat aufweist, und daß der mit einem kleinen Bandstand versehene Isolator einen Isolator darstellt, dessen sich verkleinernder Bandabstand durch Ionenimplantation erhalten wird.

3. Halbleiterstruktur nach Anspruch 1, dadurch gekennzeichnet, daß das Substrat aus Silicium besteht, wobei der mit einem großen Bandabstand versehene Isolator aus $SiO_2$ und der mit einem kleinen Bandabstand versehene Isolator aus einer dünnen $Si_3N_4$-Schicht besteht, auf der ein Metallkontakt angebracht ist.

4. Halbleiterstruktur nach Anspruch 1, dadurch gekennzeichnet, daß das Substrat aus Silicium besteht, und daß der Isolator mit einem kleinen Bandabstand aus mehreren dünnen durch Pyrolyse oder Plasma aufgetragenen Oxidschichten zusammengesetzt ist und eine wachsende Menge an überschüssigem Silicium enthält.

5. Speicherelement, dadurch gekennzeichnet, daß seine Struktur durch einen der Ansprüche 1 bis 4 definiert wird, und daß es einschließt:

im Halbleitersubstrat eingebrachte Source- und Drainbereiche,

eine zwischen dem Source- und dem Drainbereich erzeugte isolierte Gatestruktur, wobei der Bandabstand des Isolators der Gatestruktur nur in der Nähe des elektrischen Gatekontaktes verkleinert wird, um den Injektionsbereich zu erhalten.

6. Halbleiterstruktur nach einem der vorhergenenden Ansprüche, dadurch gekennzeichnet, daß die Ladungs-getterschicht eine potentialmäßig schwebende Schicht aus polykristallinem Silicium zum Ladungsspeichern darstellt.

FIG. 1a
MIS

FIG. 1b
SIMIS

FIG. 1c
GIMIS

MIS

# FIG. 2A

SIMIS

# FIG. 2B

GIMIS

# FIG. 2C

# FIG. 3

$E_{FM}$

M    $I_G$    I    S

ENERGIE

DISTANCE

$E_{C_I}$

$E_{CS_i}$

$E_{FS_i}$

$E_{VS_i}$

$E_{V_I}$

FIG. 4

CAPACITANCE pF

TENSION PORTE

VIERGE
Vg = -90V, 2'
Vg = +90V, 2'

0 016 246

FIG. 5

SiO2

Al

Si3N4

SiO2

Al

SiO2

Al

N++

N++

p-Si

COUCHE DE
PIEGEAGE

FIG. 6

Al

COUCHES
DE SiO2
PYROLYTIQUES

SiO2

Al

SiO2

SiO2

Al

N++

N++

p-Si

COUCHE DE PIEGEAGE